Europäisches Patentamt

(19) European Patent Office

Office européen des brevets

(11) Veröffentlichungsnummer: **0 053 273**
**B1**

(12) **EUROPÄISCHE PATENTSCHRIFT**

(45) Veröffentlichungstag der Patentschrift:
10.07.85

(51) Int. Cl.⁴: **G 11 C  17/00**

(21) Anmeldenummer: **81108848.3**

(22) Anmeldetag: **24.10.81**

(54) **Integrierte Schaltung mit nichtflüchtig programmierbaren Halbleiterspeichern.**

(30) Priorität: **27.11.80  DE 3044689**

(43) Veröffentlichungstag der Anmeldung:
**09.06.82 Patentblatt 82/23**

(45) Bekanntmachung des Hinweises auf die Patenterteilung:
**10.07.85 Patentblatt 85/28**

(84) Benannte Vertragsstaaten:
**DE FR GB IT NL**

(56) Entgegenhaltungen:
**IEEE JOURNAL OF SOLID-STATE CIRCUITS, Band SC-15, Nr. 3, Juni 1980, Seiten 346-353, New York, USA
ELEKTRONIK, Band 29, Nr. 7, April 1980, Seiten 48-50, München, DE.
IEEE INTERNATIONAL SOLID-STATE CIRCUITS CONFERENCE, Februar 1980, Seiten 58-59, New York, USA**

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Wilmsmeyer, Klaus, Dr. rer. nat. Dipl.-Phys., Stuttgarter Strasse 10/1, D-7809 Denzlingen (DE)**

(74) Vertreter: **Stutzer, Gerhard, Dr., Deutsche ITT Industries GmbH Patent- und Lizenzabteilung Hans-Bunte-Strasse 19 Postfach 840, D-7800 Freiburg (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Bei programmierbaren integrierten Schaltungen mit Halbleiterspeichern in Form von Isolierschicht-Speichertransistoren, deren Schwellspannungen durch Injektion von Ladungsträgern in oder aus einem Speichermedium der einzelnen Isolierschicht-Feldeffekttransistoren geändert werden können, wird nicht selten eine Fehlprogrammierung von einzelnen Speichertransistoren festgestellt, d. h. eine ungewollte Verschiebung der Schwellspannung von einzelnen Speichertransistoren. Die Erfindung beruht auf der Erkenntnis, daß zumindest ein Teil dieser Fehlprogrammierungen darauf zurückzuführen sind, daß beim ungewollten oder auch beabsichtigten Abschalten der Spannungsversorgung im Moment des Zusammenbruchs dieser Spannung unbeabsichtigte Programmierungsimpulse ausgelöst werden können, welche die Information des Speichers zerstören. Dies tritt insbesondere dann auf, wenn, wie es bei nichtflüchtigen Speichern meist der Fall ist, die Spannungsversorgung von mehreren Quellen übernommen wird.

Die Erfindung beschäftigt sich daher mit dem Problem, solche unbeabsichtigt auftretenden Programmierimpulse in einer integrierten Schaltung mit nichtflüchtigen programmierbaren Halbleiterspeichern in Form von Isolierschicht-Feldeffekttransistoren, deren Schwellspannungen zumindest beim Schreiben mittels eines kurzzeitig angelegten Schreibimpulses geändert werden können, weitgehend zu unterbinden.

Eine Übersicht über die betroffenen nichtflüchtig programmierbaren Halbleiterspeicher findet sich in der Zeitschrift »Proceedings of the IEEE« Band 64, Nr. 7 (Juli 1976), Seiten 1039 bis 1059. Bei diesen Halbleiterspeichern erfolgt zumindest das Schreiben mit Hilfe eines elektrischen Impulses, mit dessen Hilfe Ladungsträger eine ausreichend dünn bemessene Isolierschicht zu einem Speichermedium in unmittelbarer Nähe der Kanalzone eines Isolierschichtfeldeffekttransistors durchtunneln und in dem Speichermedium eingefangen werden. Gegenwärtig sind integrierte Schaltungen mit nichtflüchtig programmierbaren Halbleiterspeichern in Form von MNOS-Transistoren handelsüblich. In diesem Zusammenhang wird verwiesen auf »Siemens Forschungs- und Entwicklungsberichte«, Band 4 (1975) Nr. 4, Seiten 213 bis 219. Eine weitere Anwendung der Erfindung liegt bei Isolierschicht-Feldeffekttransistoren mit Speichermedien in Form von Gate-Elektroden mit schwebendem Potential, wie sie beispielsweise aus der Zeitschrift »IEEE Transactions on Consumer Electronics«, Band CE-26 (Februar 1980) Seiten 20 bis 25 bekannt sind.

Der Anwendungsbereich der Erfindung erstreckt sich auch auf integrierten Schaltungen mit Halbleiterspeichern, welche zwar elektrisch geschrieben, jedoch auch durch Ultraviolettstrahlung gelöscht werden können, wie sie beispielsweise aus der Zeitschrift »Electronics« vom 13. März 1980, Seiten 115 bis 121 bekannt waren.

Ein elektrisch änderbarer Festwertspeicher (EAROM) ist aus Elektronik, Band 29, No 7, April 1980, Seiten 48—50 bekannt. Dieses EAROM enthält interne Spannungssensoren, die den Speicherinhalt vor Versorgungsspannungen schützen, die außerhalb der zulässigen Toleranzen liegen und eventuell unbeabsichtigtes Einschreiben oder Löschen bewirken könnten. Insbesondere müssen die Versorgungsspannungen Vss und Vdd sowie die Programmierspannung beim Einschreiben und Löschen innerhalb der Toleranzen liegen, andernfalls kann nur ausgelesen werden. Eine Schaltung zur Durchführung dieser Schutzfunktionen wird nicht angegeben.

Die von der Erfindung betroffenen integrierten Schaltungen weisen zumindest zum Schreiben der Speichertransistoren eine Programmierlogik zumeist in einer besonderen Substratzone auf, um wahlweise in jeden der Speichertransistoren eine durch die Schwellenspannung definierte logische »Eins« oder logische »Null« einschreiben zu können. Zu diesem Zwecke sind die Gate-Elektroden der Speichertransistoren wortweise mit einer Wortleitung verbunden.

Die Erfindung betrifft somit eine integrierte Schaltung mit nichtflüchtig programmierbaren Halbleiterspeichern in Form von Isolierschicht-Speichertransistoren, deren Schwellspannungen unter Verwendung einer in einer Substratzone integrierten Programmierlogik, welche an der Versorgungsspannung Vdd liegt, mindestens beim Schreiben mittels eines kurzzeitig angelegten Schreibimpulses einer Programmierspannung Vp größer als die Versorgungsspannung Vdd durch Injektion von Ladungsträgern in oder aus einem Speichermedium der einzelnen Feldeffekttransistoren geändert werden können, gemäß dem Oberbegriff des Anspruchs 1.

Die eingangs erwähnte Aufgabenstellung der weitgehenden Verhinderung von Fehlprogrammierungen wird erfindungsgemäß durch die im kennzeichnenden Teil des Anspruchs 1 angegebene Überwachungsschaltung für die Versorgungsspannung Vdd unter Verwendung eines Schwellwertschalters mit einer integrierten Zenerdiode oder einer Reihenschaltung von mehreren integrierten Zenerdioden gelöst.

Grundsätzlich ist, wenn weder programmiert noch gelesen werden soll, die Wortleitung bzw. sind die Wortleitungen an die Substratzone der Programmierlogik zu legen. Dies gilt auch für den Fall, daß für die Programmierlogik keine eigene Substratzone vorhanden ist, worunter ein inselförmiger Bereich (»Wanne«) des einen Leitungstyps zu verstehen ist, der beispielsweise unter Verwendung einer Isolierzone des anderen Leitungstyps, welche eine auf einem Substrat des anderen Leitungstyps aufgebrachte Epitxialschicht des einen Leitungstyps rahmenförmig durchdringt, hergestellt worden ist. In manchen Fällen ist es erforderlich oder wünschenswert, auch die Programmierspannung Vp zu überwachen. Zu diesem Zweck ist in der integrierten Schaltung mit nichtflüchtig programmierbaren Halbleiterspeichern nach der Erfindung ein weiterer Schwellwertschalter integriert, dessen Spannungsversorgungsanschluß an der Programmierspannungsleitung liegt und dessen Referenzspannung an der bereits vorhandenen Referenzquelle des Schwellwertschalters zur Überwachung der Versorgungsspannung Vdd abgegriffen wird.

Ein besonderes Merkmal der Erfindung liegt in der Verwendung von integrierten Zenerdioden zur Bildung der Referenzspannung. Diese können nämlich mit den in einer Produktion erforderlichen geringen Streuungen der Zenerspannungen ohne weiteres hergestellt werden, wenn der ohnehin zum Herstellen der Drain- und Source-Zonen erforderliche Planardiffusionsprozeß zur Herstellung der einen Zone der Zenerdiode bzw. der einen Zonen der Zenerdioden ausgenutzt wird. Die andere Zone bzw. Zonen wird bzw. werden dann unter Verwendung von entgegendotierenden Verunreinigungen in einem weiteren Diffusionsprozeß diffundiert, der im allgemeinen ohnehin zur Kontaktierung der Substratzone der integrierten Programmierlogik erforderlich ist.

Die Erfindung, ihre Vorteile und deren Weiterbildungen werden im folgenden an dem Ausführungsbeispiel einer integrierten Schaltung mit Halbleiterspeichern in Form von MNOS-Speichertransistoren geschildert und anhand der Zeichnung erläutert, deren

Fig. 1 das Schaltbild einer sowohl für die Überwachung der Programmierspannung Vp als auch zur Überwachung der Versorgungsspannung Vdd geeignete Überwachungsschaltung zur Verwendung in einer integrierten Schaltung nach der Erfindung zeigt und deren

Fig. 2 und 3 zur Erläuterung der Herstellung einer Zenerdiode zur Verwendung in einer Überwachungsschaltung nach der Fig. 1 dienen.

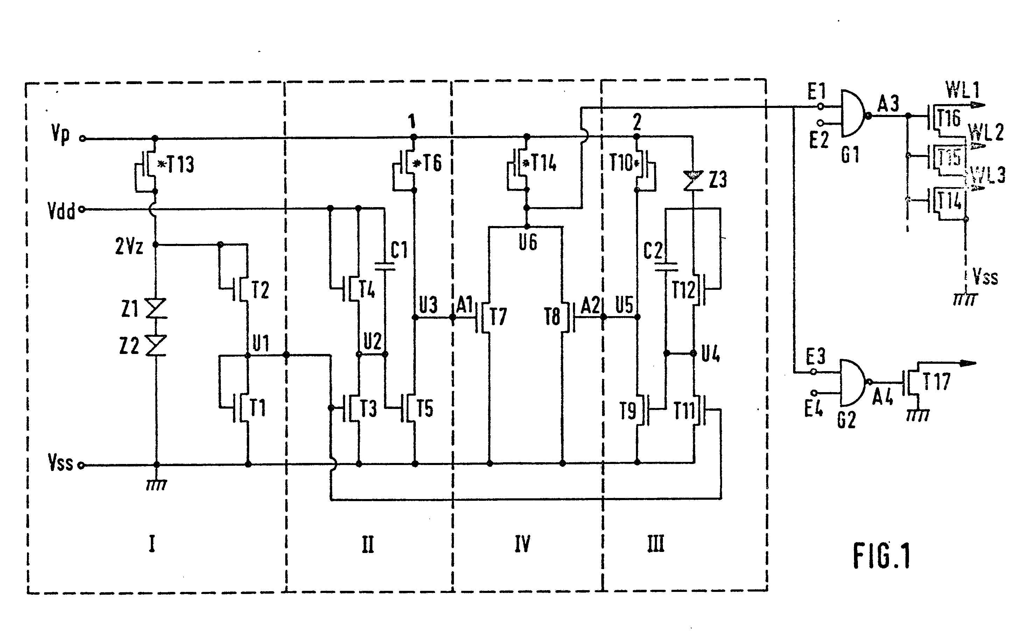

In einer integrierten Schaltung nach der Erfindung ist grundsätzlich zur Überwachung der Versorgungsspannung Vdd in der Schaltung mindestens ein Schwellwertschalter II integriert, dessen Spannungsversorgungsanschluß 1 an der Programmierspannung Vp und dessen Referenzspannung U1 an einer eine in Sperrichtung durchbrechende integrierte Zenerdiode oder eine Reihenschaltung von mehreren in Sperrichtung durchbrechenden integrierten Zenerdioden enthaltende Referenzquelle I gegen Substratpotential abgegriffen wird. Der Ausgang A1 des Schwellwertschalters II wirkt über eine geeignete Überwachungslogik auf die Wortleitungen WL1 ... WLn derart ein, daß die Wortleitungen bei Abfall der Versorgungsspannung Vdd mit der Substratzone der Programmierlogik verbunden werden. Die Überwachungslogik enthält nach dem Ausführungsbeispiel der Fig. 1 einen Inverter mit den Feldeffekttransistoren T7 und T14, dessen Ausgangssignal an den einen Eingang E1 eines NAND-Gatters G1 angelegt wird. Der Ausgang des NAND-Gatters G1 ist an die Gate-Elektroden von Transistoren T14, T15 und T16 gelegt, deren Source-Drain-Strecken zwischen den Wortleitungen WL1, WL2 und WL3 und dem Potential Vss der Substratzone der Programmierlogik liegen, so daß die Wortleitungen mit der Substratzone verbunden werden können. Am anderen Eingang E2 des NAND-Gatters G1 ist ein an der Programmierlogik abgreifbares Signal angelegt, welches der logischen »Eins« während des Lesens oder Schreibens entspricht.

Eine weitere Sicherheit gegen ungewolltes Programmieren wird durch Verwendung eines weiteren Schalter-IGFET T17 erzielt, dessen Source-Drain-Strecke die Substratzone der Speichertransistoren mit der Substratzone der Programmierlogik verbindet. Die Gate-Elektrode des weiteren Schalter-MISFETs T17 liegt am Ausgang A4 eines weiteren NAND-Gatters G2, dessen erster Eingang E3 mit dem Eingang E1 des ersten NAND-Gatters G1 verbunden ist und an dessen zweitem Eingang E4 eine logische »Eins« liegt, wenn das Substrat der Speichertransistoren, z. B. beim Löschen, eien Spannung erhalten soll.

Die Referenzspannung U1 wird an einer Zenerdiode oder wie beim Ausführungsbeispiel gemäß der Fig. 1 an zwei in Sperrichtung durchbrechenden integrierten Zenerdioden Z1 und Z2, welche die Referenzquelle I bilden, gegen Substratpotential abgegriffen. Sie erhalten ihre Spannungsversorgung von der Programmierspannungsquelle über den Lasttransistor T13, welcher als Feldeffekttransistor vom Verarmungstyp ausgebildet werden kann. Dieser wird mit der Programmierspannungsleitung verbunden.

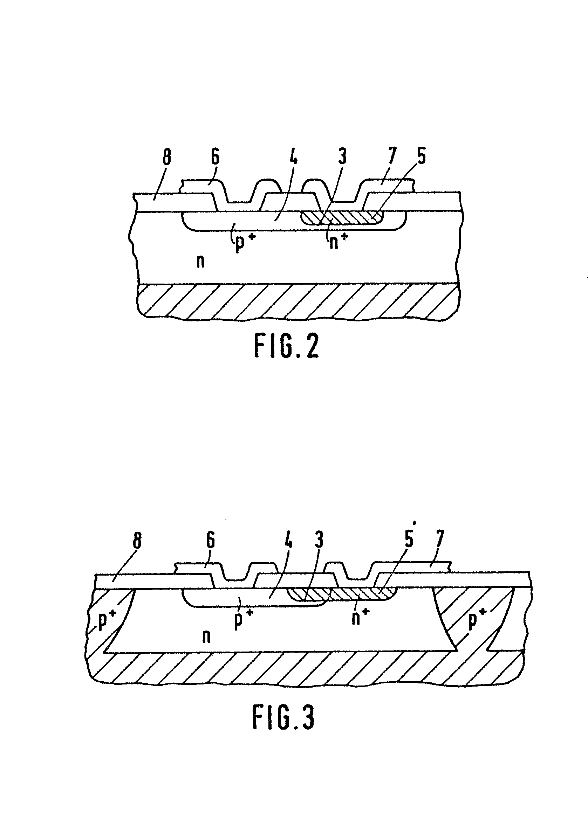

Die Zenerdioden Z1 und Z2 können ohne zusätzlichen Diffusionsprozeß hergestellt werden, indem die Diffusionsprozesse zum Herstellen der Source- und Drain-Zone (eine P+-Diffusion bei P-Kanal-Technik) und die Diffusion für die Wannenanschlußzonen (N+-Diffusion bei der P-Kanal-Technik) ausgenutzt werden. Dementsprechend weisen die den PN-Übergang 3 der Zenerdioden bildende eine Zone 4 — vgl. Fig. 2 und 3 — bzw. die PN-Übergänge der Zenerdioden Z1 und Z2 bildenden Zonen des einen Leitungstyps die gleiche Eindringtiefe und die gleiche Störstellenverteilung auf wie die Zonen der Speichertransistoren. Ausführungsformen solcher Zenerdioden veranschaulichen ausschnittweise im Querschnitt die Fig. 2 und 3.

Die eine Zone 4 wird bei der Diffusion der Source- und Drain-Zone der Speichertransistoren diffundiert, während die andere Zone 5 beim Planardiffusionsprozeß zur Herstellung von Wannenkontaktierungszonen hergestellt wird. Die andere Zone 5 der Zenerdiode kann sowohl in die eine Zone 4 eingesetzt werden, wie die Fig. 2 veranschaulicht, als auch überlappend ausgeführt werden, wie die Fig. 3 zeigt. An den Zonen 4 und 5 werden die kontaktierenden Leitbahnen 6 und 7 angebracht, welche entsprechend der üblichen Planartechnologie außerhalb der Kontaktierungsfenster auf einer isolierenden Oberflächenschicht 8, vorzugsweise aus Siliciumdioxid, verlaufen.

Es wurde festgestellt, daß die Zenerabbruchspannungen $U_Z$ der so hergestellten Dioden recht konstant sind, selbst dann, wenn die Dotierung der anderen niederohmigen Zone 5 leicht schwankt. Bei Anwendung von gängigen Diffusionsprozessen mit üblichen Oberflächenkonzentrationen werden $U_Z$-Werte von etwa 7,5 Volt erreicht.

Wegen der relativ guten Konstanz der Zenerabbruchspannungen $U_Z$ können die Zenerdioden in Verbindung mit einem Lastelement, beispielsweise dem Lasttransistor T13, als Referenzspannungsquelle verwendet werden. Der durch Serienschaltung zweier Zenerdioden Z1, Z2 und des Lasttransistors T13 erzielte Spannungswert von etwa 15 Volt wird in dem Spannungsteiler der Referenzquelle I, bestehend aus der Reihenschaltung des substratseitig liegenden Transistors T1 und dem Transistor T2, auf den niedrigeren Wert der Referenzspannung U1 herabgesetzt, welche am Verbindungspunkt der beiden Transistoren T1 und T2 abgegriffen wird. Die Referenzspannung U1 ist abhängig von der Schwellspannung $U_T$ dieser beiden Transistoren T1 und T2 und ist stets größer als $U_T$. In einer vorteilhaft benutzten Ausführungsform der Referenzquelle I der integrierten Schaltung nach der Erfindung wird der $\beta$-Wert des substratseitig liegenden Transistors T1 wesentlich größer als der des anderen Transistors T2 der Reihenschaltung gewählt, d. h. $\beta 1 \gg \beta 2$, wobei die $\beta$-Werte die Steilheitsfaktoren bedeuten, in die das Verhältnis von Kanalbreite W zur Kanallänge L der Isolierschicht-Feldeffekttransistoren mit gleichen Indizes eingehen. In diesem Fall wird U1 nur geringfügig größer als $U_T$, beispielsweise $U_T + \Delta V$. Die Drain-Zonen der beiden Transistoren T1 und T2 der Reihenschaltung werden jeweils mit ihren Gate-Elektroden verbunden, wie die Fig. 1 zeigt.

Der eigentliche Schwellwertschalter II besteht aus einer weiteren Reihenschaltung von zwei Isolierschicht-Transistoren T3 und T4 zwischen der Versorgungsspannung Vdd und dem Substratpotential Vss. Die Drain-Elektrode des Transistors T4, an der die Versorgungsspannung Vdd liegt, wird mit seiner Gate-Elektrode verbunden, während die Referenzspannung U1 an den substratseitig liegenden Transistor T3 der Reihenschaltung angelegt wird.

Wird nun die Bedingung $\frac{\beta 3}{\beta 4} = \frac{\beta 1}{\beta 2}$ weitgehend angenähert, so ist leicht einzusehen, daß für Vdd = 2 Vz

$$U2 = U1 = U_T + \Delta V$$

gilt.

Für Vdd-Spannungen in der Nachbarschaft von 2 Vz gilt in guter Näherung

$$U2 = U_T + \Delta V + Vdd - 2 Vz .$$

Der Kondensator C1 soll für eine schnelle Übertragung einer Vdd-Änderung an die Gate-Elektrode des Transistors T5 der aus der Reihenschaltung der beiden Transistoren T5 und T6 bestehenden Inverterstufe des Schwellwertschalters II sorgen. Der mit der Drain-Elektrode an die Programmierspannungsleitung angeschlossene Transistor T6, dessen Gate-Elektrode mit seiner Source-Elektrode verbunden ist, wird zweckmäßigerweise als Feldeffekttransistor des Verarmungstyps realisiert, weil damit der Inverter T5, T6 eine sehr gut definierte Schaltspannung Us besitzt, so daß $U3 < U_T$, wenn $U2 > Us$, und $U3 > U_T$, wenn $U2 < Us$ ist. Die $\beta$-Werte der Transistoren T5 und T6 werden so gewählt, daß $Us = U_T + \Delta V$ ist. Wenn gleichzeitig die obengenannte Beziehung der $\beta$-Werte der Transistoren T1, T2, T3 und T4 gilt, schaltet die Vdd-Spannung bei einem von $U_T$ unabhängigen Wert den Ausgangspegel des Inverters aus T5 und T6 von »Null« nach »Eins«.

Beim Absenken der Versorgungsspannung Vdd unter den Überwachungspegel, im Ausführungsbeispiel 2 Vz, wird die Spannung U3 stark über die Schwellspannung $U_T$ angehoben und somit der Schaltungspunkt U6 über den Invertertransistor T7 umsomehr an das Potential Vss angenähert, je größer der $\beta$-Wert des Transistors T7 gegenüber dem $\beta$-Wert des Transistors T14 ($\beta 7 \gg \beta 14$) gewählt wird. Der Transistor T14 kann vorteilhafterweise ebenfalls wie die weiteren in der Fig. 1 mit einem Stern markierten Transistoren als Transistor des Verarmungstyps ausgelegt werden.

Zur Überwachung der Programmierspannung Vp, welche als Gleichspannung an der die Schaltungspunkte 1 und 2 aufweisenden Programmierleitung anliegt, ist in der Schaltung nach der Erfindung ein weiterer Schwellwertschalter III integriert, dessen Spannungsversorgungsanschluß 2 an der Programmierspannung Vp liegt und dessen Referenzspannung U1 ebenfalls an der Referenzquelle I des Schwellwertschalters II zur Überwachung der Versorgungsspannung Vdd abgegriffen wird. Beim Ausführungsbeispiel gemäß der Fig. 2 enthält die Überwachungslogik ein NOR-Gatter IV, dessen beide Eingänge mit den Ausgängen A1 und A2 der beiden Schwellwertschalter I und III verbunden sind. Natürlich kann anstelle eines NOR-Gatters auch ein OR-Gatter verwendet werden, wobei die anschließende Logik anzupassen ist.

Zur Überwachung der Programmierspannung $V_p$ wird innerhalb des Schwellwertschalters III die Referenzspannung U1 an die Gate-Elektrode des substratseitig angeordneten Transistors T11 einer Serienschaltung aus zwei Isolierschicht-Feldeffekttransistoren T11 und T12 angelegt, die über eien weitere im Durchbruch betriebene Zenerdiode Z3 an der Programmierspannung Vp liegt. Die Drain-Elektrode des an der weiteren Zenerdiode Z3 liegenden Transistors T12 ist mit seiner Gate-Elektrode verbunden.

Um in gleicher Weise wie beim Schwellwertschalter II eine Unabhängigkeit von den in einer Produktion auftretenden Schwankungen der Schwellwerte $U_T$ zu gewährleisten, ist der Schwellwertschalter III zur Überwachung der Programmierspannung Vp analog zum Schwellwertschalter II aufgebaut. Zu diesem Zwecke ist die Beziehung

$$\frac{\beta 11}{\beta 12} = \frac{\beta 1}{\beta 2}$$

weitgehend anzunähern. Ähnlich wie beim Schwellwertschalter II wird der Verbindungspunkt der beiden Transistoren T11 und T12 mit der Spannung U4 an die Gate-Elektrode eines substratseitig liegenden Transistors T9 einer Serienschaltung aus zwei Transistoren T10 und T9 zwischen der Programmierspannungsleitung und dem Substrat angelegt. Werden $\beta 9$ und $\beta 10$ wiederum so gewählt, daß Us = $U_T + \Delta V$ ist, dann ergibt sich eine Schaltschwelle bei einer Vp-Absenkung auf 3Vz. Bei den im allgemeinen weniger zahlreichen Logikgattern, die mit Vp betrieben werden, muß gewährleistet sein, daß sie noch bis zu dieser Spannung herab (22,5 Volt) funktionieren.

Der Ausgang A2 des Schwellwertschalters III ist mit dem zweiten Eingang des NOR-Gatters IV verbunden.

Abweichungen von dem oben erläuterten Spezialfall Us = $U_T + \Delta V$ sind zur günstigeren Auslegung oder Schaltpegelfestlegung in Grenzen zulässig. Die $U_T$-Unabhängigkeit des Schaltpegels ist dann zwar nur noch näherungsweise gewährleistet, was in der Praxis jedoch meist voll ausreicht. Im übrigen ist im Schwellwertschalter III ebenfalls zur Erhöhung der Ansprechgeschwindigkeit des Schwellwertschalters III ein Kondensator C2 vorgesehen, der zwischen der Source-Elektrode und der Drain-Elektrode des mit der weiteren Zenerdiode Z3 verbundenen Transistors T12 liegt.

Die integrierte Schaltung nach der Erfindung gemäß der Fig. 1 ist für einen nichtflüchtig programmierbaren Halbleiterspeicher geeignet, der aus zwei unabhängigen Spannungsquellen betrieben wird, nämlich einer Programmierspannungsquelle mit relativ hoher Spannung und einer Versorgungsspannungsquelle für die Logik. Für einen in P-Kanal-MNOS-Technik hergestellten Halbleiterspeicher ist beispielsweise eine Programmierspannung Vp = —30 Volt und eine Versorgungsspannung Vdd von —18 Volt üblich. Bei einer integrierten Schaltung mit einem nichtflüchtig programmierbaren Halbleiterspeicher, der entsprechend der beschriebenen Ausführungsform mit einer Überwachungsschaltung gemäß der Fig. 1 ausgestattet ist, ist nicht nur ein Schutz gegen Fehlprogrammierungen bei einem Abfall der Versorgungsspannung Vdd gewährleistet, sondern dieser besteht auch bei einem Abfall der Programmierspannung Vp. In diesem Fall werden nicht nur die Wortleitungen auf das Potential Vss der Substratzone, sondern auch noch das Potential der die MNOS-Speichertransistoren enthaltende Wanne auf das Wannenpotential Vss der Logik abgesenkt.

## Patentansprüche

1. Integrierte Schaltung mit nichtflüchtig programmierbaren Halbleiterspeichern in Form von Isolierschicht-Speichertransistoren, deren Schwellenspannungen unter Verwendung einer in einer Substratzone integrierten Programmierlogik, welche an der Versorgungsspannung Vdd liegt, mindestens beim Schreiben mittels eines kurzzeitig angelegten Schreibimpulses einer Programmierspannung Vp größer als die Versorgungsspannung Vdd durch Injektion von Ladungsträgern in oder aus einem Speichermedium des einzelnen Isolierschicht-Speichertransistors geändert werden können, deren Gate-Elektroden wortweise mit je einer Wortleitung verbunden sind, deren Source- und Drain-Zonen des einen Leitungstyps in die freie Oberfläche der Substratzone der Programmierlogik oder in eine zweite Substratzone des anderen Leitungstyps eingesetzt sind, dadurch gekennzeichnet,
daß zur Überwachung der Versorgungsspannung Vdd in der Schaltung ein Schwellwertschalter (II) integriert ist, dessen Spannungsversorgungsanschluß (1) an der Programmierspannung (Vp) liegt und dessen Referenzspannung (U1) an einer in Sperrichtung durchbrechenden integrierten Zenerdiode oder an einer eine Reihenschaltung von mehreren in Sperrichtung durchbrechenden integrierten Zenerdioden enthaltenden Referenzquelle (I) gegen Substratpotential abgegriffen wird, und
daß der Ausgang (A1) des Schwellwertschalters (II) über eine solche Überwachungslogik auf die Wortleitungen (WL1 ... WLn) einwirkt, daß diese bei Abfall der Versorgungsspannung (Vdd) mit der Substratzone der Programmierlogik verbunden werden.

2. Integrierte Schaltung nach Anspruch 1, dadurch gekennzeichnet,
daß die Durchbruchspannung (Vz) der Zenerdiode oder die Summe der Durchbruchspannungen (2Vz) der in Reihe geschalteten Zenerdioden (Z1; Z2) an einen einseitig auf Substratpotential (Vss) liegenden Spannungsteiler angelegt ist, der aus einer Reihenschaltung von zwei Isolierschicht-Feldeffekttransistoren (T1, T2) besteht, deren Drain-Zonen jeweils mit den Gate-Zonen verbunden sind,
daß der $\beta$-Wert des substratseitig liegenden Isolierschicht-Feldeffekttransistors (T1) wesentlich größer ist als der des anderen Isolierschicht-Feldeffekttransistors (T2) der Reihenschaltung,
daß der Verbindungspunkt der beiden Isolierschicht-Feldeffekttransistoren (T1, T2) des Spannungsteilers, an dem die Referenzspannung (U1) abgegriffen wird, mit der Gate-Elektrode des substratseitig liegenden Isolierschicht-Feldeffekttransistors (T3) einer weiteren Reihenschaltung von zwei Isolierschicht-Feldeffekttransistoren (T3, T4) verbunden ist, an der gegen das Substratpotential (Vss) die Versorgungsspannung (Vdd) liegt, und
daß die Bedingung

$$\frac{\beta 3}{\beta 4} = \frac{\beta 1}{\beta 2}$$

weitgehend angenähert ist, wobei die $\beta$-Werte die Steilheitskonstanten der Isolierschicht-Feldeffekttransistoren mit gleichen Indizes bedeuten.

3. Integrierte Schaltung nach Anspruch 2, dadurch gekennzeichnet, daß die an der Versorgungsspannung (Vdd) liegende Drain-Elektrode des betroffenen Isolierschicht-Feldeffekttransistors (T4) der weiteren Reihenschaltung (T3, T4) mit der Source-Elektrode des betroffenen Isolierschicht-Feldeffekttransistors (T4) über eine Kapazität (C1) zur Erhöhung der Ansprechgeschwindigkeit des Schwellwertschalters (II) verbunden ist.

4. Integrierte Schaltung nach einem der Ansprüche 1 bis 3, dadurch gekennzeichnet,
daß zur Überwachung der Programmierspannung (Vp) ein weiterer Schwellwertschalter (III) in der Schaltung integriert ist, dessen Spannungsversorgungsanschluß (2) an der Programmierspannung (Vp) liegt und dessen Referenzspannung (U1) an der Referenzquelle (I) des Schwellwertschalters (II) zur Überwachung der Versorgungsspannung (Vdd) abgegriffen wird, und
daß die Überwachungslogik ein OR- oder ein NOR-Gatter (IV) enthält, dessen beide Eingänge mit den Ausgängen (A1, A2) der beiden Schwellwertschalter (I, III) verbunden sind.

5. Integrierte Schaltung nach Anspruch 4, dadurch gekennzeichnet, daß zur Überwachung der Programmierspannung (Vp)
die Referenzspannung (U1) an der Gate-Elektrode des substratseitig angeordneten Transistors (T11) einer Serienschaltung aus zwei Isolierschicht-Feldeffekttransistoren (T11, T12), die über eine weitere in Durchbruch betriebenen Zenerdiode (Z3) an der Programmierspannung (Vp) liegt, liegt,
wobei die mit der weiteren Zenerdiode (Z3) verbundene Drain-Elektrode des betroffenen Isolierschicht-Feldeffekttransistors (T12) mit dessen Gate-Elektrode verbunden ist, und
daß die Bedingung

$$\frac{\beta 11}{\beta 12} = \frac{\beta 1}{\beta 2}$$

weitgehend angenähert ist, wobei die $\beta$-Werte das Verhältnis der Steilheitskonstanten der Isolierschicht-Feldeffekttransistoren mit gleichen Indizes bedeuten.

6. Integrierte Schaltung nach Anspruch 5, dadurch gekennzeichnet, daß die mit der weiteren Zenerdiode (Z3) verbundene Drain-Elektrode mit der Source-Elektrode des betroffenen Transistors (T12) des Spannungsteilers zur Erhöhung der Ansprechgeschwindigkeit des Schwellwertschalters (III) zur Überwachung der Programmierspannung (Vp) über einen weiteren Kondensator (C2) verbunden ist.

7. Integrierte Schaltung nach einem der Ansprüche 1 bis 6, dadurch gekennzeichnet, daß die Ausgänge der beiden Schwellwertschalter (II, III) mit den Eingängen eines NOR-Gatters (IV) verbunden sind,
daß der Ausgang (U6) des NOR-Gatters (IV) am ersten Eingang (E1) eines NAND-Gatters (G1) liegt, an dessen anderem Eingang (E2) entweder eine logische »Eins« beim Lesen oder Programmieren der Speichertransistoren und sonst eine logische »Null« ansteht und
daß der Ausgang (A3) des NAND-Gatters (G1) mit den Gate-Elektroden von Schalter-Isolierschicht-Feldeffekttransistoren (T14, T15, T16) verbunden ist, welche je eine Wortleitung beim Erscheinen einer logischen »Null« am Ausgang (A3) des NAND-Gatters (G1) mit der Substratzone der Programmierlogik verbindet.

8. Integrierte Schaltung nach Anspruch 7, dadurch gekennzeichnet,
daß der Ausgang des NOR-Gatters (IV) am ersten Eingang (E3) eines weiteren NAND-Gatters (G2) liegt, an dessen anderem Eingang (E4) entweder eine logische »Eins« beim Lesen oder Programmieren der Speichertransistoren und sonst eine logische »Null« ansteht und
daß der Ausgang (A4) des weiteren NAND-Gatters (G2) mit der Gate-Elektrode eines weiteren Schalter-Isolierschicht-Feldeffekttransistors (T17) verbunden ist, welcher die Substratzone der Speichertransistoren der integrierten Schaltung mit der Substratzone der Programmierlogik verbindet.

9. Integrierte Schaltung nach einem der Ansprüche 1 bis 8, dadurch gekennzeichnet, daß die den PN-Übergang (3) bzw. die PN-Übergänge der Zenerdiode bzw. der Zenerdioden (Z1, Z2) bildende eine Zone (4) bzw. Zonen des einen Leitungstyp die gleiche Eindringtiefe und die gleiche Störstellenverteilung wie die Zone der Speichertransistoren aufweist bzw. aufweisen.

## Claims

1. Integrated circuit having non-volatile programmable semiconductor memories in the form of insulated layer storage transistors, the threshold voltages of which, by employing an integrated programming logic which is applied to the supply voltage Vdd, can be altered within a substrate zone at least during the writing operation by means of a momentarily applied writing pulse of a programming voltage Vp which is higher than the supply voltage Vdd, by way of injecting charge carriers into or out of a storage medium of the individual insulated-gate storage transistor, with the gate electrodes thereof each being connected in a word-wise manner to a word line, with the source and drain zones of the one conductivity type being inserted into the free surface of the substrate zone of the programming logic or into a second substrate zone of the other conductivity type, characterized in that for the purpose of supervising the supply voltage Vdd, a threshold switch (II) is integrated into the circuit, with the voltage supply terminal (1) thereof being applied to the programming voltage (Vp), with the reference voltage (U1) thereof being taken off a reference source (I) containing an integrated zener diode with a breakdown in the reverse direction or a series arrangement of several integrated zener diodes all with a breakdown in the reverse direction, in opposition to the substrate potential, and that the output (A1) of said threshold switch (II), via such a supervisory logic, acts upon the word lines (WL . . . WLn) in such a way that the latter in the event of a dropping supply voltage (Vdd) are connected to the substrate zone of the programming logic.

2. An integrated circuit as claimed in claim 1, characterized in

that the breakdown voltage (Vz) of said zener diode or else the sum of the breakdown voltages (2Vz) of said series-connected zener diodes (Z1, Z2) is applied to a voltage divider connected with one side to substrate potential (Vss), with said voltage divider consisting of a series arrangement of two insulated-gate field-effect transistors (T1, T2) whose drain zones are each connected to the gate zones,

that the $\beta$-value of said insulated-gate field-effect transistor (T1) as arranged on the substrate side, is substantially higher than that of the other one of said insulated-gate field-effect transistors (T2) of said series arrangement,

that the point connecting said two insulated-gate field-effect transistors (T1, T2) of said voltage divider, at which said reference voltage (U1) is taken off, is connected to the gate electrode of the insulated-gate field-effect transistor (T3) arranged on the substrate side, of a further series arrangement of two insulated-gate field-effect transistors (T3, T4) to which there is applied said supply voltage (Vdd) with respect to said substrate potential (Vss), and

that the condition

$$\frac{\beta 3}{\beta 4} = \frac{\beta 1}{\beta 2}$$

is extensively approximated, with the $\beta$-values being indicative of the mutual-conductance constants of said insulated-gate field-effect transistors marked with the same indices.

3. An integrated circuit as claimed in claim 2, characterized in that the drain electrode of the respective insulated-gate field-effect transistor (T4) of said further series arrangement (T3, T4) as applied to said supply voltage (Vdd), is connected to the source electrode of the respective insulated-gate field-effect transistor (T4) via a capacitance (C1) for the purpose of increasing the operating speed of said threshold switch (II).

4. An integrated circuit as claimed in any one of claims 1 to 3, characterized in that for the purpose of supervising said programming voltage (Vp) a further threshold switch (III) is integrated into the circuit, whose voltage supply terminal (2) is applied to said programming voltage (Vp) and whose reference voltage (U1) is taken off said reference source (I) of said threshold switch (II) for supervising said supply voltage (Vdd), and

that said supervisory logic contains either an OR or a NOR gate (IV) the two inputs of which are connected to the outputs (A1, A2) of said two threshold switches (I, III).

5. An integrated circuit as claimed in claim 4, characterized in that for the purpose of supervising said programming voltage (Vp) said reference voltage (U1) is applied to the gate electrode of the transistor (T11) arranged on the substrate side, of a series arrangement consisting of two insulated-gate field-effect transistors (T11, T12) which, via a further breakdown-operated zener diode (Z3) is applied to said programming voltage (Vp),

with the drain electrode of the involved insulated-gate field-effect transistor T12 as connected to said further zener diode (Z3) being connected to the gate electrode thereof, and

that the condition

$$\frac{\beta 11}{\beta 12} = \frac{\beta 1}{\beta 2}$$

is extensively approximated, with the $\beta$-values being indicative of the relationship of the mutual-conductance constants of the insulated-gate field-effect transistors marked with the same indices.

6. An integrated circuit as claimed in claim 5, characterized in that the drain electrode as connected to said further zener diode (Z3), is connected to the source electrode of the respective transistor (T12) of said voltage divider for indreasing the responsive speed of said threshold switch (III) for supervising said programming voltage (Vp), via a further capacitor (C2).

7. An integrated circuit as claimed in any one of claims 1 to 6, characterized in that the outputs of said two threshold switches (II, III) are connected to the inputs of a NOR gate (IV),

that the output (U6) of said NOR gate (IV) is applied to the first input (E1) of a NAND gate (G1) at the other input (E2) of which there either appears a logic »one« during the reading or programming of the storage transistors, and otherwise a logic »zero«, and

that the output (A3) of said NAND gate (G1) is connected to the gate electrodes of switch IGFETs (T14, T15, T16) which connect one word line each upon appearance of a logic »zero« at the output (A3) of said NAND gate (G1), to the substrate zone of said programming logic.

8. An integrated circuit as claimed in claim 7, characterized in

that the output of said NOR gate (IV) is applied to the first input (E3) of a further NAND gate (G2), at the other input (E4) of which there either appears a logic »one« during the reading or programming of said storage transistors, and otherwise a logic »zero«, and

that the output (A4) of said further NAND gate (G2) is connected to the gate electrode of a further switch IGFET (T17) which connects the substrate zone of said storage transistors of the integrated circuit to the substrate zone of said programming logic.

9. An integrated circuit as claimed in any one of claims 1 to 8, characterized in that said zone (4) or zones of the one conductivity type forming the pn junction (3) or pn junctions of said zener diode or zener diodes (Z1, Z2), has or have the same depth of penetration and the same impurity distribution as the zone of said storage transistors respectively.

## Revendications

1. Circuit intégré avec mémoires à semiconducteurs programmables non volatiles sous la forme de transistors à effet de champ à grille isolée dont les tensions de seuil, grâce à un circuit logique de programmation intégré dans une zone du substrat reliée à la tension d'alimentation $V_{dd}$, peuvent être modifiées au moins à l'criture à l'aide d'une impulsion d'écriture brièvement appliquée de la tension de programmation $V_p$ supérieure à la tension d'alimentation $V_{dd}$, par injection ou prélèvement de porteurs de charge dans un milieu de mémorisation des différents transistors à effet de champ, dont les électrodes de grille sont reliées mot par mot à une ligne de mot, dont les zones de source et de drain d'un type de conductibilité sont insérées à la surface libre de la zone de substrat du circuit logique de programmation ou dans une seconde zone de substrat de l'autre type de conductibilité, caractérisé en ce qu'est intégré au circuit pour surveiller la tension d'alimentation $V_{dd}$ un commutateur à seuil (II) dont le raccordement d'alimentation en tension (1) est relié à la tension de programmation ($V_p$) et dont la tension de référence (U1) est prélevée par rapport au potentiel du substrat à une source de référence (I) comprenant une diode Zener ingrée à avalanche dans le sens de non-conduction ou un montage en série de plusieurs diodes Zener intégrées à avalanche dans le sens de non-conduction et en ce que la sortie (A1) du commutateur à seuil (II) agit sur les lignes de mots [WL1 à WLn] par un circuit logique de surveillance tel que, en cas de chute de la tension d'alimentation ($V_{dd}$), celles-ci sont reliées à la zone de substrat du circuit logique de programmation.

2. Circuit intégré selon la revendication 1, caractérisé en ce que la tension de Zener ($V_Z$) de la diode Zener ou la somme des tensions de Zener (2 $V_Z$) des diodes Zener montées en série (Z1, Z2) est appliquée à un diviseur de tension relié unilatéralement au potentiel du substrat ($V_{SS}$) se composant du montage en série de deux transistors à effet de champ à grille isolée (T1, T2) dont les zones de drain sont reliées aux zones de grille, en ce que la valeur $\beta$ d'un transistor à effet de champ à grille isolée (T1) est nettement plus élevée que celle de l'autre transistor à effet de champ à grille isolée (T2) du montage en série, en ce que le point de liaison des deux transistors à effet de champ à grille isolée (T1, T2) du diviseur de tension sur lequel est prélevée la tension de référence (U1) est relié à l'électrode de grille du transistor à effet de champ à grille isolée (T3) situé côté substrat d'un autre montage en série de deux transistors à effet de champ à grille isolée (T3, T4) présentant la tension d'alimentation ($V_{dd}$) par rapport au potentiel du substrat ($V_{SS}$) et en ce que la condition $\beta 3/\beta 4 = \beta 1/\beta 2$ est largement approchée, les valeurs $\beta$ étant les constantes de pente des transistors à effet de champ à grille isolée de même indice.

3. Circuit intégré selon la revendication 2, caractérisé en ce que l'électrode de drain reliée à la tension d'alimentation ($V_{dd}$) du transistor à effet de champ à grille isolée (T4) du second circuit en série (T3, T4) est reliée à l'électrode de source de ce transistor à effet de champ à grille isolée (T4) par un condensateur (C1) pour augmenter la vitesse de réponse du commutateur à seuil (II).

4. Circuit intégré selon l'une des revendications 1 à 3, caractérisé en ce que ce circuit intègre pour surveiller la tension de programmation ($V_p$) un autre commutateur à seuil (III) dont le raccordement d'alimentation en tension (2) est relié à la tension de programmation ($V_p$) et dont la tension de référence (U1) est prélevée à la source de référence (I) du commutateur à seuil (II) surveillant la tension d'alimentation ($V_{dd}$) et en ce que le circuit logique de surveillance comprend une porte OU ou OU-NON (IV) dont les deux entrées sont reliées aux deux sorties (A1, A2) des deux commutateurs à seuil (II, III).

5. Circuit intégré selon la revendication 4, caractérisé en ce que, pour surveiller la tension de programmation ($V_p$), la tension de référence (U1) est appliquée à l'électrode de grille du transistor (T11) situé côté substrat d'un montage en série de deux transistors à effet de champ à grille isolée (T11, T12), qui est reliée, par l'intermédiaire d'une autre diode Zener (Z3) exploitée en avalanche, à la tension de programmation ($V_p$), tandis que l'électrode de drain du transistor à effet de champ à grille isolée (T12) reliée à l'autre diode Zener (Z3) est reliée à son électrode de grille, et en ce que la condition $\beta 11/\beta 12 = \beta 1/\beta 2$ est largement approchée, les valeurs $\beta$ étant le rapport des constantes de pente des transistors à effet de champ à grille isolée de même indice.

6. Circuit intégré selon la revendication 5, caractérisé en ce que l'électrode de drain reliée par l'autre diode Zener (Z3) avec l'électrode de source du transistor (T12) du diviseur de tension est reliée par un autre condensateur (C2) pour augmenter la vitesse de réponse du commutateur à seuil (III) de surveillance de la tension de programmation ($V_p$).

7. Circuit intégré selon l'une des revendications 1 à 6, caractérisé en ce que les sorties des deux commutateurs à seuil (II, III) sont reliées aux entrées d'une porte OU-NON (IV), en ce que la sortie (U6) de la porte OU-NON (IV) est reliée à la première entrée (E1) d'une porte ET-NON (G1) à la seconde entrée (E2) de laquelle est appliqué soit un »un« logique pour la lecture ou la programmation des transistors de mémoire, soit un »zéro« logique dans les autres cas, et en ce que la sortie (A3) de la porte ET-NON (G1) est reliée aux électrodes de grille des transistors à effet de champ à grille isolée (T14, T15, T16) qui relient chacun une ligne de mot à la zone de substrat du circuit logique de programmation en cas d'apparition d'un »zéro« logique à la sortie (A3) de la porte ET-NON (G1).

8. Circuit intégré selon la revendication 7, caractérisé en ce que la sortie de porte OU-NoN (IV) est reliée à la première entrée (E3) d'une autre porte ET-NON (G2) à la seconde entrée (E4) de laquelle est appliqué soit un »un« logique pour la lecture ou la programmation des transistors de mémoire, soit un »zéro« logique dans les autres cas, et en ce que la sortie (A4) de l'autre porte ET-NoN (G2) est reliée à l'électrode de grille d'un autre transistor à effet de champ à grille isolée (T17) qui relie la zone du substrat des transistors de mémoire du circuit intégré et la zone du substrat du circuit logique de programmation.

9. Circuit intégré selon l'une des revendications 1 à 8, caractérisé en ce que l'unique zone (4) ou les zones d'un type de conduction formant la transition PN (3) ou les transitions PN de la ou des diodes Zener (Z1, Z2) présentent la même profondeur de pénétration et la même distribution des pièges que la zone des transistors de mémoire.

FIG.1

WL1 WL2 WL3

T16 T15 T14

Vss

T17

A3 G1 E1 E2

A4 G2 E3 E4

Z3
T10* T12 C2 U4 T11
2 U5 T9
A2 T8
T6* T14 U6
A1 T7
1 U3 T5
C1 T4 U2 T3

III IV II

T13* T2 U1 T1
2Vz Z1 Z2
Vp Vdd Vss

I

11

FIG. 2

FIG. 3